# EUROPEAN PATENT APPLICATION

(11) **EP 2 216 823 A1**
(43) Date of publication of application: **11.08.2010**
(21) Application number: 08706416.8
(22) Date of filing: 29.01.2008
(51) Int. Cl.: H01L 31/0224, H01L 21/288

(54) **METHOD FOR ELECTROCHMICAL DEPOSITING METAL ELECTRODE OF SOLAR CELL**

(30) Priority: 30.11.2007 CN 200710188267
(71) Applicant: Wuxi Suntech Power Co., Ltd., New District Wuxi Jiangsu 214-028 (CN)
(72) Inventor: JI, Jingjia, Wu Xi Jiangsu 214028 (CN); WENHAM, Stuart, Wu Xi Jiangsu 214028 (CN); CHEN, Liping, Wu Xi Jiangsu 214028 (CN); SHI, Zhengrong, Wu Xi Jiangsu 214028 (CN)
(74) Representative: Solf, Alexander
(86) International application number: PCT/CN2008/000220
(87) International publication number: WO 2009/070945

(57) **Abstract**

A method for electrochemically depositing a metal electrode of a solar cell, comprising the steps of: making the surface of the solar cell having a cathode contact with an electrolyte solution, connecting an anode of the solar cell and a solid metal, illuminating the main light-receiving surface of the solar cell, wherein metal ions in the electrolyte solution accept electrons formed on the cathode surface of the solar cell so that a metal is formed and deposited on the cathode surface of the solar cell, meanwhile, the solid metal provides electrons to the anode of the solar cell so that the metal ions are formed and dissolved in the electrolyte solution. By using this method, a problem of a decreased cell efficiency due to a short circuit caused by the deposition of metal on the anode will be solved, meanwhile, a possibility of damaging the solar cell and depositing metal unevenly as a result of using any kind of plating fixtures is avoided, the electrochemical reaction rate is effectively controlled, an evenness of the deposition of metal is guaranteed, and the manufacture of a solar cell having a selective diffusion structure is promoted.

## Description

### Technical field

The invention generally relates to a method for electrochemically depositing metal, and especially relates to a method for electrochemically depositing a metal electrode on a cathode surface of a solar cell.

### Background Technique

Currently, most methods for forming conductive electrodes of a commercial solar cell comprise the steps of: screen-printing a cathode surface of a solar cell with a silver paste and an anode surface of the solar cell with an aluminum paste, and simultaneously forming a conductive cathode and a conductive anode on the cathode and anode of the solar cell, respectively, by co-firing at high temperature. The advantage of this method for forming conductive electrodes of a solar cell is that, the process is simple and dependable, and is prone to be applied to a large-scale production.

However, a simple process of forming conductive electrodes of a solar cell by screen printing and co-firing limits the increase of the photoelectric conversion efficiency of the solar cell. For ensuring a preferable Ohmic contact between the paste for screen-printing and the surface of the solar cell after being co-fired, and for ensuring the reduction in a series resistance of the solar cell, not only a metal fingers should be designed to be wider (generally wider than 100 microns), but also an emitter square resistance should be designed to be lower (generally 50 ohm per square). The design of the wide metal fingers reduces a valid work area of the solar cell, and the design of the lower emitter square resistance reduces a short-circuit current of the solar cell. These are main reasons why the photoelectric conversion efficiency of a current commercial solar cell is low.

Obviously, one of main measures of enhancing the photoelectric conversion efficiency of a solar cell is increasing its emitter square resistance. However, after the emitter square resistance of the solar cell is increased, if the processes of screen-printing a paste and co-firing are still adopted, the contact resistance of the solar cell will be increased, and thus the photoelectric conversion efficiency of the solar cell will be reduced. Therefore, one of problems which must be solved after the emitter square resistance of a solar cell increased is to reduce the contact resistance between a conductive metal electrode and the solar cell.

One of methods for resolving the above-mentioned problem is adopting a selective diffusion process. The so-called selective diffusion process refers to making different areas of the emitter of the solar cell with square resistances of two different values, namely, the area where the conductive metal electrode is formed with a lower square resistance, and the other light-receiving surface with a higher square resistance. This technological design enhances a short-circuit current of the solar cell, as well as decreases a contact resistance between conductive metal electrodes and the solar cell. Therefore, the selective diffusion process is one of main measures of enhancing the photoelectric conversion efficiency of the solar cell.

Nevertheless, it's difficult to apply the above-mentioned processes of screen-printing and co-firing to a solar cell being selectively diffused. The main reason is that, in the process of screen-printing, it is hard to align a metal paste to the area with a lower square resistance on the emitter of the solar cell.

Usually, to solve the alignment problem, the method of chemically depositing a conductive metal electrode on the surface of a solar cell is used instead of the method of screen printing. In a buried contact solar cell, a conductive metal electrode is formed on the emitter of the solar cell by chemically depositing a metal, such as copper. The method concretely comprises the steps of: covering the emitter surface having a higher square resistance of a solar cell with a passive film or an antireflective film, laser-etching grooves on the passive film, carrying out deep diffusion for reducing the square resistance of the groove area on the emitter surface, and chemically depositing metal to form a conductive metal electrode of the solar cell on its emitter area having a lower square resistance.

The process of chemically depositing copper is an extremely slow-moving chemistry process. Generally, it takes about ten hours to obtain a conductive metal electrode with a required thickness. For avoiding the problems of stress and adsorption due to a high speed of the deposition, the rate of chemically depositing a conductive metal electrode is generally controlled to be slower than 2 microns per hour.

The method for forming the solar cell electrode by chemically depositing metal also has another problem, namely, the service life of a solution for chemically depositing metal is short. Generally, the solution can only be used for several batches. So when the method of chemically depositing metal is used on a large-scale production, a great deal of waste liquid will be produced. Since there are some organic substances which are difficult to be disposed in the discharged waste liquid, the use of the process of chemically depositing metal increases the production cost of the solar cell.

More than that, the solution for chemically depositing metal is quite unsteady and the phenomenon of metal self-separation occurs easily, which may affect a normal production. Moreover, the process condition of chemically depositing metal must be controlled sternly. For example, the temperature of the solution for chemically depositing copper must be controlled strictly. For reducing the possibility of copper self-separation, when chemically depositing copper, both air bubbling and filtration are required. For keeping the stability of the solution density, it is also required to constantly add a complement liquid. The adding of the complement liquid must be controlled very strictly, since too much complement liquid will result in copper self-separation and too little will reduce the rate of depositing copper.

Moreover, most operations of chemically depositing copper are implemented at a temperature higher than room temperature, for example, higher than 50□. Such a process needs a great deal of energy supply, which further increases the cost. Since the reaction time is long, the amount of the energy consumed during the production is considerable.

The above problem is solved by a plating process, instead of the process of chemically depositing metal. Compared with the process of chemically depositing metal, the advantage of the plating process is that its speed of depositing metal is fast. When the plating process is adopted, the time during which a conductive electrode of the solar cell is formed is shortened to within one hour from about ten hours when using the process of chemically depositing metal. Generally, if the plating process is adopted, the process of forming the conductive electrode of the solar cell can be completed between 10 to 20 minutes.

Another advantage of the use of the plating process instead of the process of chemically depositing metal is that, it has a larger operation range and is especially suitable for industrial production because the process of electrochemically depositing metal is simpler than the process of chemically depositing metal. For example, the requirement for temperature is not strict and this process can be carried out at room temperature. This is advantageous for the production control, and economizes the cost needed for heating. The composition of the electrolyte solution used in the plating process is also very simple, so the electrolyte solution generally can be repeatedly used for a long time.

Furthermore, the conductive electrode of the solar cell formed by a general chemistry deposition process is in amorphous state, while the conductive electrode of the solar cell deposited electrochemically is in micro-crystal state. Therefore, the conductive metal electrode deposited electrochemically has better conductivity performance. As a result, the plated metal electrode can reduce the loss of current produced by the solar cell on the conductive metal electrode, thereby improving the photoelectric conversion efficiency of the solar cell.

The plating process is highly suitable for industrial production because the chemistry of depositing metal by the plating process is very simple, for example, the variety in the pH value of the electrolyte solution and the composition of the solution has a little influence on the plating process, and the management to the solution is also quite simple. More importantly, the production cost of the conductive metal electrode of the solar cell formed by the plating process is very low, and the processing of the waste liquid in the plating process is also simpler than that in the process of chemically depositing metal.

However, there is still certain difficulty in practically applying the traditional plating process to the large-scale production of the solar cell. A main problem is the contact between a plating fixture and the solar cell, and the evenness of the metal plated on the solar cell. The above-mentioned plating fixture is an important tool during a traditional plating operation. One of the functions of the plating fixture during the plating operation is to fix the object to be plated in a certain position or in a certain range; another function of the plating fixture is to conduct the current of an external power supply to the object to be plated.

In fact, the resistance of the surface of a solar cell is very large before metallization. Generally, a contact resistance between the plating fixture and the surface of the solar cell is very large, which finally results in poor evenness of the metal plated on the surface of the solar cell. Moreover, since the semi-conductor material for forming the solar cell is fragile, a crack of the solar cell often occurs during loading/unloading the solar cell on/from the plating fixture.

Usually, the method for resolving the above-mentioned problem caused by the mechanical and electrical contact of the solar cell and the plating fixture is that, immersing the solar cell in an electrolyte, and then depositing a conductive metal electrode on the solar cell by using the electric energy generated by the solar cell subjected to illumination. Since the conductive metal electrode is formed on the surface of the solar cell by way of the electric energy generated by the solar cell after being illuminated, in this method traditional plating fixtures are not needed to conduct the current of an external power supply to the surface to be plated of the solar cell, so that various problems caused by using the plating fixtures are solved.

Nevertheless, this method which actualizes the deposition of metal on the surface of a solar cell by using the electric energy generated by the solar cell itself also has many defects. First, for protecting metal on the anode surface of the solar cell, a direct current power supply should be provided in addition. The anode of the direct current power supply is connected to a metal located in an electrolyte solution, and the cathode of the direct current power supply is connected to the anode metal of the solar cell located in the electrolyte solution. Only such a connection can ensure that the metal on the anode of the solar cell will not be damaged while metal is deposited on the cathode of the solar cell. In fact, such a connection used for depositing metal may make metal to be deposited on the cathode and the anode of the solar cell at the same time, which results in an unnecessary increase of the production cost.

This method has another disadvantage. Since the electric potential on the cathode surface of the solar cell is a summation of the electric potential generated by the solar cell and the electric potential of the external power supply, this is, the electric potential on the cathode surface of the solar cell depends on not only the electric potential generated by the solar cell, but also the electric potential applied to the solar cell by the external power supply. Therefore, the evenness of the metal plated on the surface of the solar cell depends on not only the evenness of the illumination on the surface of the solar cell, but also the evenness of the electric potential applied to the solar cell by the external power supply. For example, only very fine contact of a whole surface can achieve a well uniform electric potential on the cathode surface of the solar cell. In fact, it is very difficult to actualize such an even contact in industrial production.

### Summary of the Invention

Aiming at the above-mentioned defects in the prior art, one object of the invention is to provide a process for actualizing the electrochemical deposition of metal on the surface of a solar cell which utilizes the characteristic that the solar cell will generate an electric potential after accepting illumination.

Further, another object of the invention is to provide a process of electrochemically depositing metal which can ensure that a metal will only be deposited on the cathode surface of the solar cell.

Furthermore, yet another object of the invention is to provide a process of electrochemically depositing metal on the cathode surface of the solar cell in which the rate of depositing metal can be effectively controlled.

The last object of the invention is to provide a process of electrochemically depositing metal on the cathode surface of the solar cell which is suitable for a large-scale production.

For achieving the above mentioned objects, the invention provides a method for electrochemically depositing a metal electrode of a solar cell, the method comprising the steps of:
making the surface of the solar cell having a cathode contact with an electrolyte solution,
connecting an anode of the solar cell and a solid metal,
illuminating the main light-receiving surface of the solar cell by a light source,
   wherein metal ions in the electrolyte solution accept the electrons formed on the cathode surface of the solar cell so that a metal is formed and deposited on the cathode surface of the solar cell, meanwhile, the solid metal provides electrons to the anode of the solar cell so that the metal ions are formed and dissolved in the electrolyte solution.

Preferably, the solar cell does not contact the electrolyte solution except for its surface having the cathode.

Preferably, the surface contacting the electrolyte solution of the solar cell only comprises the cathode.

Preferably, the surface contacting the electrolyte solution of the solar cell may comprise the cathode and the anode at the same time.

Preferably, the electrolyte solution includes metal ions, acid radicals, water and additives.

Preferably, the electrolyte solution comprises at least one metal ion.

Preferably, the electrolyte solution comprises at least one acid radical.

Preferably, the electrolyte solution comprises at least one additive.

Preferably, the main light-receiving surface is the surface contacting the electrolyte solution, or the surface of the solar cell which does not contact the electrolyte solution,.

Preferably, within the step of illuminating, the light source for illuminating is the natural light or the light emitted by an illuminator.

Preferably, within the step of illuminating, the surface of the solar cell is illuminated by light directly or by light passing through the electrolyte or other mediums.

Preferably, the anode of the solar cell is connected electrically with the solid metal by a conductive wire.

Preferably, the solid metal is composed of as least one metal or alloy.

Preferably, at least one surface of the solid metal contact the electrolyte solution.

Preferably, the method further comprises the step of connecting an external power supply between the anode of the solar cell and the solid metal.

Preferably, the external power supply is a direct current power supply whose cathode is connected with the anode of the solar cell and whose anode is connected with the solid metal.

Preferably, the output power of the direct current power supply is not less than zero.

Preferably, the composition of the solid metal is the same as the composition of the metal deposited on the surface of the cathode of the solar cell.

Preferably, the solar cell is fixed above the electrolyte solution.

Preferably, the solar cell is moved along the horizontal direction.

During the process of electrochemically depositing metal of the invention, metal ions can only be deposited on the cathode of the solar cell, so that a problem of the reduced cell efficiency caused by a short-circuit due to the deposition of metal on the anode is solved at root, while possibilities of damaging the solar cell caused by any kind of electrical contact and the unevenness of the deposition of metal are avoided.

Another advantage of the invention is that, an external power supply is not needed to protect metal on the other surface of the solar cell since the other surface of the solar cell does not contact the electrolyte solution. Therefore, the electric potential on the surface of the solar cell changes from zero, and can be controlled effectively, so that the rate of an electrochemical reaction on the cathode surface of the solar cell can be controlled.

Another important advantage of the invention is that, since an evenness of the illumination intensity is ensured, the electric potential over the whole surface of the solar cell is quite even, so that the metal is very evenly deposited over the whole cathode surface of the solar cell.

Yet another advantage of the invention is that, an effect of self-aligning can be achieved. This advantage is especially useful for forming a solar cell having a selective diffusion structure.

### Explanations of the drawings

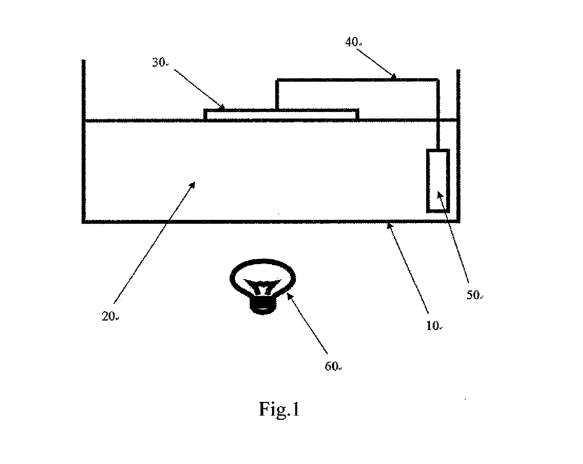

Fig. 1 is a schematic view of carrying out an electrochemical reaction on the cathode surface of a solar cell to deposit metal by using the method of electrochemically depositing metal of the invention.

### Detailed Specification of Embodiments

The concrete embodiments will be described below with reference to the drawing.

Fig. 1 is a schematic view of carrying out an electrochemical reaction on the cathode surface of a solar cell to deposit metal by using the method of electrochemically depositing metal of the invention.

As shown in Fig.1, the devices used in the method of electrochemically depositing metal of the invention are mainly comprise an electrolytic tank 10, an electrolyte solution 20, a solar cell 30, a conductive metal wire 40, a metal block 50 and an illuminator 60.

A main function of the electrolytic tank 10 is containing the electrolyte solution 20. In the case where the main light-receiving surface of the solar cell 30 is its cathode surface, another function of the electrolytic tank 10 of the invention is permitting the light emitted by the illuminator 60 to pass through and irradiate on the main light-receiving surface of the solar cell 30. Thus, the electrolytic tank 10 of the invention may be made of a transparent and corrosion-resisting material, such as quartz, glass, a transparent organic material and so on.

In the case where the main light-receiving surface of the solar cell does not comprise its cathode, namely, its light-receiving surface and cathode surface are two surfaces of the solar cell respectively, the illuminator should be located above the solar cell, so that the light emitted by the illuminator can directly irradiate the upper surface of the solar cell.

The electrolyte solution 20 in the electrolytic tank 10 of the invention is composed mainly of metal ions and acid radicals, such as copper sulphate, nickel chloride, and so on. According to different requirements for the deposited metal, the electrolyte solution 20 may comprise only one metal ion or more.

Similarly, According to different requirements for the deposited metal, the electrolyte solution 20 may comprise only one acid radical or more, such as sulfate radical and nitrate radical.

For reducing the stress of the deposited metal and enhancing the flatness of the deposited metal, an appropriate additive may be added in the electrolyte solution 20 according to different electrolyte solutions and the process of electrochemically depositing metal.

One important technical feature of the invention is that, only the surface having the cathode of the solar cell 30 contacts the electrolyte solution 20 and the other surface does not contact the electrolyte solution 20.

For the simplicity of industrial production, two surfaces of more than 90% commercial solar cells are the cathode and anode, respectively. Therefore, the method of the invention is especially adapted for depositing metal on the commercial solar cell. When the method of the invention is used for the above commercial solar cell, an external power supply is not necessary for protecting metal on the anode of the solar cell, since the anode is located on the reverse side of the cathode and does not contact the electrolyte solution.

As shown in Fig.1, the conductive wire 40 is electrically connected between the solid metal 50 and the solar cell 30. Generally, the main composition of the solid metal 50 is the same as the composition of the metal to be deposited on the cathode surface of the solar cell 30.

The solid metal 50 may be a metal with a single composition, or be an alloy composed of more than one metal. The solid metal 50 can be placed at any position in the electrolytic tank 10 while it has a good contact with the electrolyte solution 20. When the cathode surface of the solar cell 30 is the main light-receiving surface, the position of the solid metal 50 must not influence the irradiation of the light emitted by the illuminator 60 on the surface of the solar cell 30.

Fig.1 shows a complete reaction process of electrochemically depositing a metal electrode on the cathode surface of the solar cell by the method of the invention.

Different from the traditional plating process, the electrochemical reaction of the invention does not need electric energy provided from external, but is realized using electric energy generated by the solar cell itself.

In Fig.1, the illuminator 60 is located below the electrolytic tank 10. The position of the illuminator 60 depends on the structure of the solar cell 30. In the case where the cathode of the solar cell 30 is its main light-receiving surface, the lower surface, i.e. the cathode surface, of the solar cell 30 is irradiated by the light emitted by the illuminator 60 passing through the transparent electrolytic tank 10 and the electrolyte solution 20.

A solar cell is a device converting a light energy to an electric energy. After the solar cell is irradiated by the light, a negative potential is generated on the surface of the emitter, i.e. the cathode. Thus, the illumination allows the solar cell 30 to release electrons after generating the negative potential. Metal ions in the electrolyte solution 20 driven by the negative potential move toward the cathode, and then a metal atom is formed and deposited on the cathode surface of the solar cell 30 after the metal ions accept electrons on the cathode surface of the solar cell 3 0. At the same time, under the function of a positive potential of the anode of the solar cell 30, the solid metal 50 in the electrolyte solution 20 constantly losses electrons through the conductive wire 40 to form metal ions to be dissolved in the electrolyte solution 20, so that the density of the metal ions in the electrolyte solution 20 is kept constant. At last, an electrochemical reaction process is realized without an external power supply.

Different from the plating process that requires an external power supply, the above process of electrochemically depositing metal of the invention does not need any external power supply, but carries out the whole electrochemical reaction by way of the electric potential generated by the solar cell 30 itself after being illuminated. During the above process, the metal ions thus can only be deposited on the cathode of the solar cell 30.

This characteristic has very important sense in industrial production of the solar cell. If the electrochemical reaction is carried out with an external power supply, the metal will be deposited on the both cathode and anode unprotected on the surfaces of solar cell, which results in a short-circuit of the solar cell and decreases the photoelectric conversion efficiency of the solar cell. And in the method of the invention, even if the anode surface is exposed, it is impossible for the metal to be deposited on the anode of the solar cell since the anode can only accept electrons rather than release electrons after the solar cell is subjected to illumination. Therefore, the problem of the decreased cell efficiency caused by the short-circuit of the anode is solved at root.

At the same time, since a solar cell slice is generally about 200µm in thickness, any locally physical contact will easily cause crack. And since the process of electrochemically depositing metal of the invention needs no external power supply, there is no electric contact during the electrochemistry process of the invention, so that the possibility of damaging the solar cell slice is avoided.

Further, since the resistance of the cathode surface of the solar cell is generally large, an outside electric contact will result in an unevenness of the electric potential on the cathode surface of the solar cell, in turn an unevenness of the metal deposited on the surface of the solar cell. And in the electrochemical reaction of the invention, as long as the illumination intensity on the surface of the solar cell is even, the electric potential generated by the solar cell is even over its whole surface, namely, the metal is evenly deposited on its surface.

On the other hand, in the electrochemical reaction process of the invention, the surface having the cathode of the solar cell contacts the electrolyte solution and the other surface of the solar cell does not contact the electrolyte solution, so that it is not necessary to use an external power supply to protect metal on the other surface of the solar cell. As a result, the electric potential on the surface of the solar cell may change from zero, the rate of the electrochemical reaction on the cathode surface of the solar cell may be better controlled, and the rate of electrochemically depositing metal may be changed arbitrarily by varying the illuminating intensity.

The metal produced by the method of the invention is very evenly deposited on the cathode surface of the solar cell. The reason is that the electric potential generated by the solar cell is directly proportional to the illuminating intensity accepted by the solar cell. The potential over the whole surface of the solar cell is very even on the condition of the even illuminating intensity, and will not be influenced by the position, the shape and the size of the anode metal block. An even electric potential brings an even electrochemical reaction rate, in turn an even metal deposition layer.

The method of the invention is especially useful for producing the solar cell having a selective diffusion structure. For reducing the reflective rate of the solar cell, an antireflective film for reducing the reflective rate is generally plated on the surface having a high square resistance of the solar cell. The antireflective film acts as a mask during the process of electrochemically depositing metal of the invention and prevents the electrons generated by the cathode of the solar cell from contacting the metal ions in the electrolyte solution. And the electrons generated by the surface having a low square resistance, which has been selectively diffused and is not protected by the mask, of the solar cell contact the metal ions in the electrolyte solution, that is, an electrochemical reaction occurs, and a conductive metal electrode is formed on its surface.

The process of electrochemically depositing metal of the invention may be carried out intermittently or continuously.

During a process of intermittently electrochemically depositing metal, the solar cell 30 of the invention is fixed above the electrolyte solution 20 with its surface having the cathode contacting the electrolyte solution 20. When the solar cell 30 receives the light emitted by the illuminator 60, the metal ions in the electrolyte solution 20 receive electrons from the cathode surface of the solar cell, then a metal is formed and deposited on the cathode surface of the solar cell.

During a process of continuously electrochemically depositing metal, the solar cell 30 of the invention is moved along a horizontal direction. The means for moving the solar cell 30 may be a roller or a moveable carriage. For example, the solar cell 30 may be placed on a group of rollers with its surface having a cathode contacting the electrolyte solution 20 below it. As this group of rollers rotates toward a certain direction, the solar cell 30 is moved along a certain direction on this group of rollers to realize the process of continuously electrochemically depositing metal.

The followings are several detailed embodiments of using the method of the invention.

### 1. The First Embodiment

The first step is fabricating a traditional solar cell as follows:
A P-type silicon slice is processed by texturing, diffusing, edge etching, coating a silicon-nitride film on an N-type surface, screen-printing an aluminum paste on an P-type surface, screen-printing a silver paste on the N-type surface and firing to make a solar cell whose photoelectric conversion efficiency is measured as 16.57%, and the open circuit voltage, the current density, the series resistance, the parallel resistance and the filling factor of the solar cell are 625mV, 35.3mA/cm2, 0.0075Ω, 13.11Ω and 75.1%, respectively.

The second step is preparing electrolyte solutions:
Preparation of a copper electrolyte solution: evenly dissolving 200g of copper sulfate, 120g of sulfuric acid and 4.5ml of brightening agent VF100 in 1L of water.
Preparation of a tin electrolyte solution: evenly dissolving 50g of stannous sulfate, 60g of sulfuric acid, 48g of thymosulfonic acid and 2.4g of cresol in 1L of water.

The third step is electrochemically depositing metal:
The cathode surface of the solar cell is contacted with the above copper electrolyte solution, and the anode of the solar cell is connected with a solid copper in the copper electrolyte solution. An illuminator is placed below a transparent electrolytic tank. After the solar cell is irradiated by light for 15 minutes, it is measured that the thickness of the copper layer deposited on the cathode conductive electrode of the solar cell is about 10µm.

Then the cathode of the solar cell after the above step is contacted with the above mentioned tin electrolyte solution, and the anode of the solar cell is connected with a solid tin in the tin electrolyte solution. The illuminator is placed below the transparent electrolytic tank. After the solar cell is irradiated by light for 1 minute, it is measured that the thickness of the tin layer deposited on the cathode conductive electrode of the solar cell is about 0.01µm. At the same time, it is measured that the photoelectric conversion efficiency of the solar cell has been improved to 16.94%, and its open circuit voltage is 626mV, the current density is 35.2mA/cm2, the series resistance is 0.0045Ω, the parallel resistance is 49.41Ω and the filling factor is 76.9%.

### 2. The Second Embodiment

The first step is fabricating a buried contact solar cell as follows:
A P-type silicon slice is processed by texturing, shallowly diffusing, edge etching, oxidizing, laser-etching buried contact grooves on an N-type surface, deeply diffusing inside the buried contact grooves, sputtering aluminium on a P-type surface and firing the aluminium, chemically plating nickel inside the buried contact grooves, and forming a nickel-silicon alloy after firing the nickel.

The second step is preparing electrolyte solutions:
Preparation of a nickel electrolyte solution: evenly dissolving 150g of nickel sulfate, 8g of sodium chloride, 30g of boric acid and 40g of anhydrous sodium sulfate in 1L of water.
Preparation of a copper electrolyte solution: evenly dissolving 200g of copper sulfate, 120g of sulfuric acid and 4.5ml of brightening agent VF100 in 1L of water.
Preparation of a copper-zinc alloy electrolyte solution: evenly dissolving 75g of cuprous cyanide, 9g of zinc cyanide, 55g of sodium cyanide, 10g of sodium carbonate and 4g of sodium fluoride in 1L of water.

The third step is electrochemically depositing the cathode metal of the buried contact solar cell:
The cathode surface of the solar cell is contacted with the above nickel electrolyte solution, and the anode of the solar cell is connected with a solid nickel in the nickel electrolyte solution. An illuminator is placed below the transparent electrolytic tank. After the solar cell is irradiated by light for 5 minutes, it is measured that the thickness of the nickel layer deposited inside the buried contact grooves of the solar cell is about 0.1µm.

Then the cathode surface of the solar cell after the above step is contacted with the above mentioned copper electrolyte solution, and the anode of the solar cell is connected with a solid copper in the copper electrolyte solution. The illuminator is placed below the transparent electrolytic tank. After the solar cell is irradiated by light for 20 minutes, it is measured that the thickness of the copper layer deposited inside the buried contact grooves of the solar cell is about 15µm.

Then the cathode surface of the solar cell after the above steps is contacted with the above mentioned copper-zinc alloy electrolyte solution, and the anode of the solar cell is connected with a solid copper-zinc alloy in the copper-zinc alloy electrolyte solution. The illuminator is placed below the transparent electrolytic tank. After the solar cell is irradiated by light for 2 minutes, it is measured that the thickness of the copper-zinc alloy layer deposited inside the buried contact grooves of the solar cell is about 0.01 µm. At the same time, it is measured that the photoelectric conversion efficiency of the solar cell is 17.53%, the open circuit voltage is 620mV, the current density is 35.7mA/cm2, the series resistance is 0.0040Ω, the parallel resistance is larger than 100Ω and the filling factor is 79.2%.

### 3. The Third Embodiment

The first step is fabricating a solar cell with a whole-back conductive electrode as follows:
An N-type silicon slice is processed by texturing, N-type diffusing, oxidizing, opening the contact area for a P-type electrode with a photoresist as a mask, P-type deeply diffusing, opening the contact area for an N-type electrode with a photoresist as a mask, chemically plating nickel on the electrode contact areas, and forming a nickel-silicon alloy after firing the nickel.

The second step is preparing electrolyte solutions:
Preparation of a nickel electrolyte solution: evenly dissolving 150g of nickel sulfate, 8g of sodium chloride, 30g of boric acid and 40g of anhydrous sodium sulfate in 1L of water.
Preparation of a copper electrolyte solution: evenly dissolving 200g of copper sulfate, 120g of sulfuric acid and 4.5ml of brightening agent VF100 in 1L of water.
Preparation of a copper-tin electrolyte solution: evenly dissolving 20g of cuprous cyanide, 30g of sodium stannate, 20g of sodium cyanide and 10g of sodium hydroxide in 1L of water.

The third step is electrochemically depositing an electrode of the solar cell with a whole-back conductive electrode:
The conductive electrode surface of the solar cell is contacted with the above nickel electrolyte solution, and the anode of the solar cell is connected with a cathode of an external power supply whose anode is connected with a solid nickel in the nickel electrolyte solution. An illuminator is placed above the solar cell. The current output of the external power supply is controlled to be 1A. After the solar cell is irradiated by light for 5 minutes, it is measured that the thickness of the nickel layer deposited on the cathode surface and the anode surface of the solar cell is about 0.1µm and 0.08µm, respectively.

Then the conductive electrode surface of the solar cell after the above step is contacted with the above mentioned copper electrolyte solution, and the anode of the solar cell is connected with a cathode of an external power supply whose anode is connected with a solid copper in the copper electrolyte solution. The illuminator is placed above the solar cell. The current output of the external power supply is controlled to be 1.5A. After the solar cell is irradiated by light for 20 minutes, it is measured that the thickness of the copper layer deposited on the cathode surface and the anode surface of the solar cell is about 15µm and 12µm, respectively.

Then the conductive electrode surface of the solar cell after the above steps is contacted with the above mentioned copper-tin electrolyte solution, and the anode of the solar cell is connected with a cathode of an external power supply whose anode is connected with a solid copper and a solid tin in the copper-tin electrolyte solution. The illuminator is placed above the solar cell. The current output of the external power supply is controlled to be 0.5A. After the solar cell is irradiated by light for 2 minutes, it is measured that the thickness of the copper-tin layer deposited on the cathode surface and the anode surface of the solar cell is about 0.01µm and 0.008µm, respectively. At the same time, it is measured that the photoelectric conversion efficiency of the solar cell is 18.02%, its open circuit voltage is 620mV, the current density is 36.9mA/cm2, the series resistance is 0.0051Ω, the parallel resistance is larger than 100Ω and the filling factor is 78.8%.

The invention is especially suitable for the solar cell whose cathode and anode located on the different surfaces respectively.

For example, the cathode and anode of most commercial solar cells are provided on two different surfaces thereof, respectively. The main light-receiving surface of the commercial solar cell is its cathode surface. For decreasing the lightproof area of its electrode, the cathode conductive metal electrode of this solar cell is composed of many fingers. The anode of this commercial solar cell is located on another surface. When the invention is applied to the solar cell with this structure, its cathode surface contacts the electrolyte solution while its anode surface contacts a solid metal and does not contact the electrolyte solution. It is easy to realize the continuous production with this process of electrochemical reaction.

The invention is also suitable for the solar cell whose cathode and anode are located on the same surface.

For eliminating the lightproof area of the conductive electrode and enhancing the photoelectric conversion efficiency, both the cathode and anode of a solar cell may be located on the reverse side of the main light-receiving surface of the solar cell. When the invention is applied to the solar cell with this kind of structure, the surface having the cathode and anode of the solar cell contacts the electrolyte solution. An external power supply is connected between the anode of the solar cell and a solid metal, while an illuminator is placed above the solar cell. When the illuminator emits light and the external power supply outputs electric energy, the reaction of electrochemically depositing metal takes place synchronously on the cathode and anode of the solar cell, namely, the conductive metal electrodes of the cathode and anode are formed at the same time. The rate of depositing metal on the cathode and anode can be adjusted by regulation of the luminous intensity of the illuminator and the power supply strength of the external power supply.

The invention is not limited to the above special embodiments. A person skilled in the art may make various changes and modifications without departing from the spirit and nature of the invention, which should fall within the protection scope of the claims attached to the invention.

## Claims

1. A method for electrochemically depositing a metal electrode of a solar cell, **characterized by** comprising the steps of:
making the surface of the solar cell (30) having a cathode contact with an electrolyte solution (20),
connecting an anode of the solar cell (30) and a solid metal (50),
illuminating the main light-receiving surface of the solar cell (30) by a light source (60),
wherein metal ions in the electrolyte solution (20) accept electrons formed on the cathode surface of the solar cell (30) so that a metal is formed and deposited on the cathode surface of the solar cell (30), meanwhile, the solid metal (50) provides electrons to the anode of the solar cell so that the metal ions are formed and dissolved in the electrolyte solution (20).

2. The method according to claim 1, **characterized in that** the solar cell (30) does not contact the electrolyte solution (20) except for its surface having the cathode.

3. The method according to claim 1, **characterized in that** the surface contacting the electrolyte solution (20) of the solar cell (30) only comprises the cathode.

4. The method according to claim 1, **characterized in that** the surface contacting the electrolyte solution (20) of the solar cell (30) comprise both the cathode and the anode.

5. The method according to claim 1 or 2, **characterized in that** the electrolyte solution (20) includes metal ions, acid radicals, water and additives.

6. The method according to claim 5, **characterized in that** the electrolyte solution (20) comprises at least one metal ion.

7. The method according to claim 5, **characterized in that** the electrolyte solution (20) comprises at least one acid radical.

8. The method according to claim 5, **characterized in that** the electrolyte solution (20) comprises at least one additive.

9. The method according to claim 1, **characterized in that** the main light-receiving surface is the surface contacting the electrolyte solution (20) of the solar cell (30).

10. The method according to claim 1, **characterized in that** the main light-receiving surface is the surface of the solar cell (30) which does not contact the electrolyte solution (20).

11. The method according to claim 1, **characterized in that** within the step of illuminating, the light source (60) for illuminating is the natural light or the light emitted by an illuminator.

12. The method according to claim 1, **characterized in that** within the step of illuminating, the surface of the solar cell (30) is directly illuminated by light.

13. The method according to claim 1, **characterized in that** within the step of illuminating, the surface of the solar cell (30) is illuminated by light passing through the electrolyte or other mediums.

14. The method according to claim 1, **characterized in that** the anode of the solar cell (30) is connected electrically with the solid metal (50) by a conductive wire (40).

15. The method according to claim 1 or 14, **characterized in that** the solid metal (50) is composed of at least one metal.

16. The method according to claim 1 or 14, **characterized in that** the solid metal (50) has at least one surface contacting the electrolyte solution (20).

17. The method according to claim 1, **characterized in that** further comprising the step of connecting an external power supply between the anode of the solar cell (30) and the solid metal (50).

18. The method according to claim 17, **characterized in that** the external power supply is a direct current power supply whose cathode is connected with the anode of the solar cell (30) and whose anode is connected with the solid metal (50).

19. The method according to claim 18, **characterized in that** the output power of the direct current power supply is not less than zero.

20. The method according to claim 1, **characterized in that** the composition of the solid metal (50) is the same as the composition of the metal deposited on the cathode surface of the solar cell (30).

21. The method according to claim 1, **characterized in that** the solar cell (30) is fixed above the electrolyte solution (20).

22. The method according to claim 1, **characterized in that** the solar cell (30) is moved along a horizontal direction.
